# EUROPEAN PATENT APPLICATION

(11) **EP 1 688 764 A2**
(43) Date of publication of application: **09.08.2006**
(21) Application number: 06002340.5
(22) Date of filing: 06.02.2006
(51) Int. Cl.: G02B 1/11, B29D 11/00

(54) **Optical component and method for manufacturing the same**

(30) Priority: 08.02.2005 JP 2005031978; 08.02.2005 JP 2005031979; 20.10.2005 JP 2005305898
(71) Applicant: SEIKO EPSON CORPORATION, Shinjuku-ku, Tokyo 163-0811 (JP)
(72) Inventor: Shibuya, Munehiro, Suwa-shi Nagano-ken 392-8502 (JP); Noguchi, Takashi, Suwa-shi Nagano-ken 392-8502 (JP); Kanai, Toshihito, Suwa-shi Nagano-ken 392-8502 (JP)
(74) Representative: HOFFMANN EITLE

(57) **Abstract**

A method for manufacturing a plastic optical component having an optical multilayer film. The optical multilayer film has a low refractive index layer and a high refractive index layer, and a layer containing titanate of a rare earth element is formed in a vacuum atmosphere at pressure more than 1 × 10⁻⁴ Pa and less than 1 × 10⁻² Pa as the high refractive index layer of the optical multilayer film.

## Description

### 1. Technical Field

The present invention relates to a plastic optical component having an optical multilayer film and a method for manufacturing the component.

### 2. Related Art

In optical components such as spectacle lenses, optical multilayer films are formed on the surfaces thereof for obtaining antireflection effect, filter effect, or the like. These optical multilayer films are obtained by alternately laminating materials having different refractive indexes.

Here, in the case where a base material of the optical component is plastic, as materials forming an optical multilayer film, materials by which layers can be formed at relatively low base material temperature without deforming plastic and predetermined properties can be obtained are used. As the predetermined properties, there are refractive index, hardness, transparency, etc. As such materials, silicon dioxide or the like is used as a low refractive index material, and zirconium oxide, titanium oxide, tantalum oxide, or the like is used as a high refractive index material.

For example, a plastic spectacle lens is provided with a hard coating layer for scratch resistance and an antireflection coating. The hard coating layer is formed on the lens surface and the antireflection coating is formed by alternately laminating materials having different refractive indexes on the surface of the hard coating layer. Plastic used for such base material and hard coating layer deteriorates (yellowing, peeling, or the like) due to ultraviolet. In order to prevent the deterioration, a method using a hard coating layer containing rutile type titanium dioxide that absorbs ultraviolet and has low photoactivation has been known (see JP-A-11-310755 (claim 7, paragraphs [0067] and [0068])).

On the other hand, as a method for forming an optical multilayer film, the vacuum evaporation method of heating and melting materials that form the optical multilayer film in a vacuum atmosphere to evaporate and deposit the materials on a base material is generally used.

Here, in the case where titanium oxide, tantalum oxide, or the like is used in the vacuum evaporation method, ion assisted evaporation is generally performed because absorption at visible wavelengths easily occurs due to oxygen loss.

However, maintenance on ion assist requires time and the maintenance cycle becomes shorter. Further, there are problems that titanium oxide, tantalum oxide, or the like is likely to cause bumping (a phenomenon that gas is released due to sudden heating and causes evaporation materials to fly off) etc. Accordingly, gradual heating is required for preventing the phenomenon and it takes time.

As a material by which absorption at visible wavelengths is likely to occur and bumping is likely to occur, lanthanum titanate (La₂Ti₂O_{6.5}) has been known (e.g., see JP-A-6-235803 (claim 3, paragraphs [0016] to [0024])).

There are problems with stress of the optical multilayer film formed on the plastic base material other than the above described problems with the optical multilayer film itself and the method for manufacturing the film.

For example, as a method for preventing deformation of the base plate and breaking of film due to stress, as a method for cancelling internal stress of an adjacent layer having compression stress (e.g., a silicon dioxide layer), a method for forming a layer containing lanthanum and titanium and having tensile stress by means for forming a layer with high film density (ion plating or the like) has been known (e.g., see JP-A-2003-277911 (claim 2, paragraphs [0008] to [0013])).

However, in the related example in JP-A-11-310755, when a lanthanum titanate layer is formed by vacuum evaporation, there is a problem that the layer transmits even light having wavelengths near 275 nm and the light resistance of the base material and the hard coating layer to ultraviolet is low.

Further, the base material of the optical component as plastic has a large coefficient of thermal expansion (2 to 12 x 10⁻⁵/°C). On the other hand, the inorganic materials forming the optical multilayer film have small coefficients of thermal expansion (5 × 10⁻⁷/°C for silicon dioxide). Accordingly, when the base material expands due to heat, cracking occurs in the optical multilayer film because it can not bear the expansion. The cracking deteriorates the appearance and optical characteristics of the optical multilayer film. It is considered that the temperature at which cracking occurs is related to the stress of the optical multilayer film. However, the problem of JP-A-6-235803 is not a problem with heat resistance reduction related to stress, and includes no specific disclosure on a film forming method for the purpose of improving heat resistance reduction related to film stress. Furthermore, lanthanum titanate described in JP-A-6-235803 is used for the purpose of preventing absorption of visible light, but not used for improvements in light resistance.

Moreover, in JP-A-2003-277911, breaking of the optical multilayer film when the base material expands due to heat is not described or improvements in heat resistance of plastic optical component with an optical multilayer film formed are not suggested.

### SUMMARY

Therefore, an advantage of some aspects of the invention is to provide a plastic optical component having an optical multilayer film with improved heat resistance, scratch resistance, appearance, and light resistance, and a method for manufacturing the component.

A method for manufacturing an optical component according to an aspect of the invention is a method for manufacturing a plastic optical component having an optical multilayer film. The optical multilayer film has a low refractive index layer and a high refractive index layer, and a layer containing titanate of a rare earth element is formed in a vacuum atmosphere at pressure more than 1 x 10⁻⁴ Pa and less than 1 x 10⁻² Pa as the high refractive index layer of the optical multilayer film.

The inventors have found that the improvement in heat resistance is difficult when a layer having tensile stress exists in the optical multilayer film as a result of keen study. That is, since the optical multilayer film is formed by layers having compression stress, even when the plastic base material expands due to heat, because each layer of the optical multilayer film has compression stress, the optical multilayer film expands while the compression stress of each layer is released. Therefore, the optical multilayer film expands while sufficiently following the base material and cracking becomes less likely to occur in the optical multilayer film. Consequently, optical components with improved heat resistance can be manufactured.

Here, the stress of the layer formed in the optical multilayer film depends on the forming methods (base material temperature, pressure at the time of layer formation), properties of structure materials, etc. In the normal vacuum evaporation method without ion assist, the energy of particles reaching the base material is small. Accordingly, the layer density becomes lower and tensile stress is more likely to be generated. Especially, the structure materials of the high refractive index layer are likely to generate tensile stress at the normal pressure (10⁻⁵ to 10⁻¹ Pa) during vacuum evaporation. Here, since an ultra vacuum device is required to keep the pressure less than 10⁻⁵ Pa, there are limitations regarding device, and, at the pressure more than 10⁻¹ Pa, the energy of evaporation particles is reduced and layer formation becomes difficult. The pressure in vacuum evaporation is determined by the balance between exhaust performance and transpiration rate of evaporation material.

As a property of a material forming the optical multilayer film, for example, a layer formed by zirconium oxide has tensile stress (CONCISE ENCYCLOPEDIA OF CHEMICAL TECHNOLOGY 3 issued by Kyoritsu Shuppan Co., Ltd., the first impression of the first edition issued September 30, 1960).

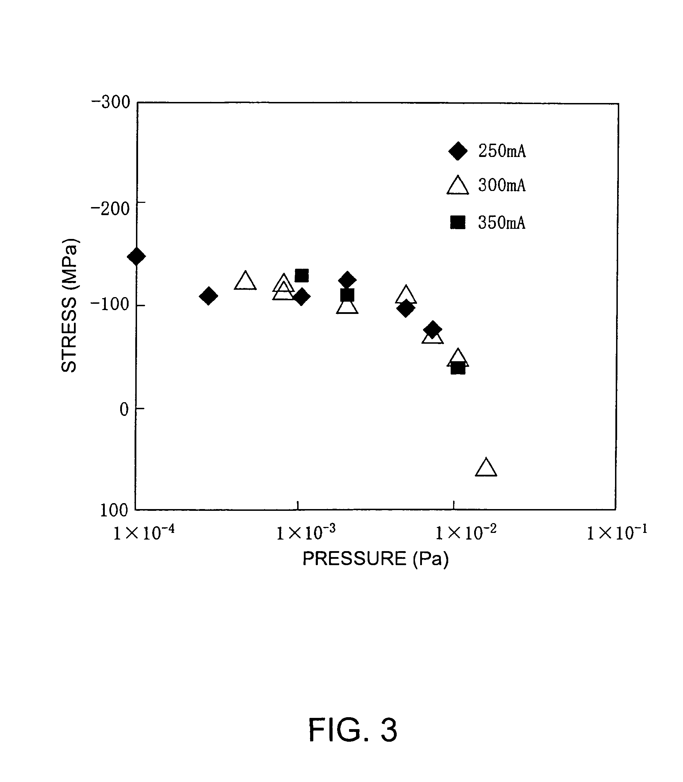

The inventors have found that, when layers containing titanate of a rare earth element is formed in a vacuum atmosphere at pressure less than 1 x 10⁻² Pa as the high refractive index layers, these layers have compression stress (see Fig. 3, the negative stress is compression stress).

In this case, not only the low refractive index layer having compression stress, but also a layer having compression stress is formed as the high refractive index layer. That is, when the plastic base material expands due to heat, because each layer of the optical multilayer film has compression stress, the optical multilayer film expands while the compression stress of each layer is released. Therefore, the optical multilayer film expands while sufficiently following the base material and cracking becomes less likely to occur in the optical multilayer film. Consequently, the temperature at which cracking occurs in the multilayer film becomes higher and optical components with improved heat resistance can be manufactured.

Note that a low refractive index layer is a generic term used to refer to a layer with lower refractive index than that of the high refractive index layer, and also includes a so-called middle refractive index layer. For example, aluminum oxide or the like is used as a middle refractive index layer.

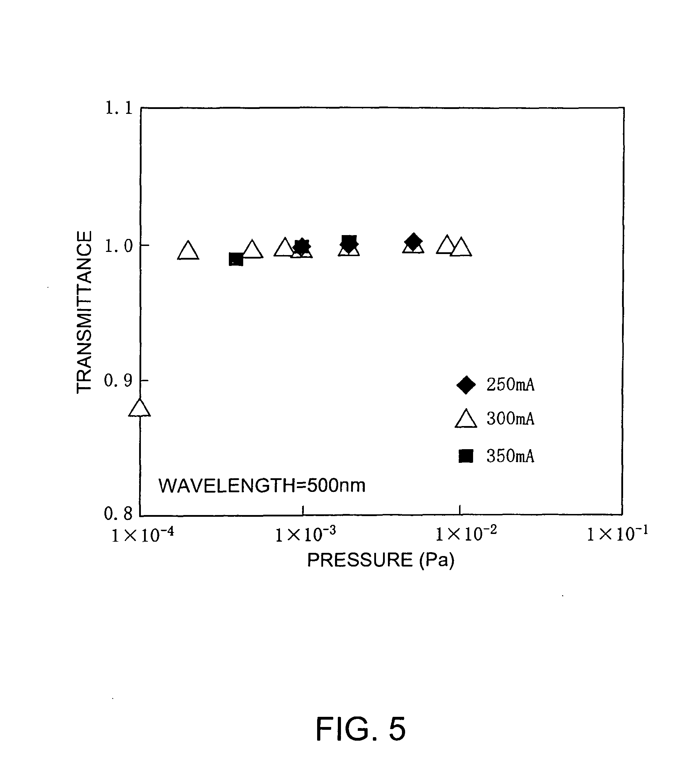

Further, in this case, the high refractive index layer is preferably formed in a vacuum atmosphere at pressure more than 1 x 10⁻⁴ Pa. More preferably, the pressure is equal to or more than 2 × 10⁻⁴ Pa and, even more preferably, the pressure is equal to or more than 1 × 10⁻³ Pa. When the pressure lower limit at the time of formation of the high refractive index layer exceeds 1 x 10⁻⁴ Pa, the high refractive index layer with less absorption of visible light due to oxygen loss of titanate is formed (see Fig. 5).

It is preferable that the high refractive index layer closest to a base material of the optical component is formed in a vacuum atmosphere at pressure equal to or more than 5 x 10⁻³ Pa and the high refractive index layer farthest from the base material of the optical component is formed in a vacuum atmosphere at pressure equal to or less than 5 × 10⁻³ Pa.

Here, the base material of the optical component refers to a target object on the surface of which the multilayer film is formed like a lens base material on which the multilayer film is formed.

In this case, the preferable pressure range can be changed by changing pressure conditions of the respective layers. That is, by setting the high refractive index layer closest to the base material of the optical component into a high pressure condition equal to or more than 5 × 10⁻³ and the high refractive index layer farthest from the base material of the optical component into a low pressure condition equal to or less than 5 x 10⁻³ Pa, the optical component more advantageous in heat resistance, scratch resistance, and appearance can be obtained.

Specifically, since the high refractive index layer closest to the base material of the optical component is formed at pressure equal to or more than 5 x 10⁻³ Pa by vacuum evaporation, the film density of the high refractive index layer is reduced and irregularities (defective appearance) on the base material surface due to high film density becomes less likely to occur. Further, the component is also advantageous in heat resistance because the pressure is less than 1 x 10⁻² Pa. Furthermore, since the high refractive index layer farthest from the base material of the optical component is formed at pressure equal to or less than 5 × 10⁻³ Pa, the film density of the high refractive index layer is increased and scratch resistance is improved. Further, the component becomes harder to absorb visible light and never inhibit the transparency because it is formed at pressure more than 1 x 10⁻⁴ Pa.

It is preferable that a layer containing lanthanum titanate is preferably formed as the high refractive index layer.

In this case, since the lanthanum titanate has compression stress in the above described pressure range, optical components with further improved heat resistance can be manufactured.

It is preferable that a layer containing silicon dioxide is preferably formed as the low refractive index layer.

In this case, since silicon dioxide has large compression stress in the vacuum evaporation method and the lanthanum titanate of the high refractive index layer also has compression stress in the above described pressure range, optical components with improved heat resistance can be manufactured by the combination of them.

An optical component according to a further aspect of the invention is manufactured by the above described method for manufacturing the optical component.

In this case, optical components with improved heat resistance can be obtained.

It is preferable that the optical component is preferably a spectacle lens.

In this case, a spectacle lens with improved heat resistance can be obtained. In the spectacle lens used with naked eyes, occurrence of cracking is a critical problem in appearance and safety. Therefore, the improvement in heat resistance is especially helpful. Further, the absorption of visible light by the high refractive index layer obtained in the above described pressure range is absorption at a level with no problem for use in the spectacle lens.

It is preferable that it is preferable that the optical component includes: a lens base material; a hard coating layer provided on the lens base material; and an antireflection coating provided on the hard coating layer and having a low refractive index layer containing silicon dioxide and a high refractive index layer containing lanthanum titanate, and the hard coating layer includes at least one of the following (1) and (2): (1) rutile type titanium dioxide particles; and (2) particles with nucleuses containing titanium oxide covered by metal oxide with low photoactivation.

Since silicon dioxide used for the low refractive index layer transmits ultraviolet, the degree of transmission of ultraviolet is determined by the high refractive index layer. However, lanthanum titanate used for the high refractive index layer transmits even from visible light to light at wavelength near 275 nm. Here, by providing the hard coating layer containing at least one of (1) rutile type titanium dioxide with low photoactivation and (2) particles having nucleuses containing titanium oxide covered by metal oxide with low photoactivation on the surface of the base material, ultraviolet is absorbed by the hard coating layer and the light resistance of the base material and the hard coating layer itself is improved.

The improvement in light resistance is considered according to the following mechanism.

Anatase type titanium dioxide absorbs ultraviolet and produces electron holes, and thereby, generates hydroxyl radical (having strong oxidizing power to cut bonding between organic materials), while rutile type titanium dioxide has larger band gap energy and produces less electron holes than anatase titanium dioxide. Further, since the radical is generated near the surface of the titanium oxide, even when the anatase titanium dioxide is used, the external influence by the radical is prevented by covering the exterior thereof with metal oxide with low photoactivation.

Therefore, the hard coating layer absorbs ultraviolet and the influence by hydroxyl radical is reduced, and thereby, the light resistance of the base material and the hard coating layer itself is improved.

Especially, since lanthanum titanate transmits even light having wavelengths near 275 nm, the hard coating layer acts more effectively to improve light resistance.

### BRIEF DESCRIPTION OF THE DRAWINGS

Fig. 1 is a schematic sectional view of an optical component according to the embodiment of the invention.

Fig. 2 is a schematic view showing an evaporation device according to the embodiment of the invention.

Fig. 3 is a view showing changes of stress to pressure.

Fig. 4 is a view showing changes of refractive index to pressure.

Fig. 5 is a view showing changes of transmittance to pressure.

Fig. 6 is a view showing calculated values of reflection characteristic of an antireflection coating in Working example 1.

Fig. 7 is a view showing calculated values of reflection characteristic of an antireflection coating in Working example 2.

Fig. 8 is a view showing calculated values of reflection characteristic of an antireflection coating in Working example 3.

Fig. 9 is a view showing calculated values of reflection characteristic of an antireflection coating in each design.

### DESCRIPTION OF EXEMPLARY EMBODIMENTS

Hereinafter, an embodiment of the invention will be described according to the drawings.

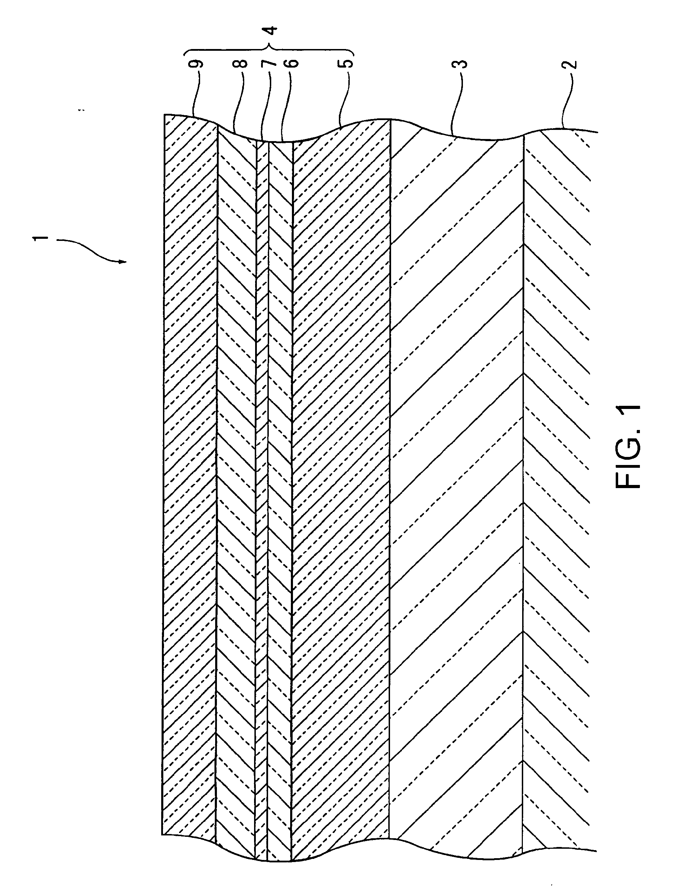

Fig. 1 shows an enlarged sectional view of a plastic spectacle lens 1 as an optical component according to the embodiment. In the arrangement, a low refractive index layer 5 is at the side of a base material 2.

In Fig. 1, a hard coating layer 3 for scratch resistance is provided on the surface of the base material 2 of the plastic spectacle lens 1. Further, on the surface of the hard coating layer 3, an antireflection coating 4 as an optical multilayer film of five layers is provided.

Here, the antireflection coating 4 is formed by alternately laminating low refractive index layers 5, 7, 9 and high refractive index layers 6, 8. In the arrangement, the low refractive index layer 5 is at the side of the base material 2.

For the base material 2, acrylic resin, thiourethane resin, methacrylic resin, allyl resin, episulfide resin, polycarbonate, polystyrene, ethyleneglycol bis allyl carbonate (CR-39), polyvinyl chloride, halogen-containing copolymer, or sulfur-containing copolymer as transparent plastic is used.

The refractive index of the base material 2 is preferably 1.6 or more to conform the refractive index of the hard coating layer 3 containing titanium oxide. Especially, allyl carbonate resin, acrylate resin, methacrylate resin, and thiourethane resin are preferable.

Note that the base material 2 may not be transparent plastic as long as it is an optical component for reflection. Further, it may be a composite material of plastic containing inorganic matter.

The hard coating layer 3 is formed by a single organic material, a single inorganic material, or a composite material of them, and the composite material is preferable in points that hardness can be obtained and refractive index can be adjusted. By adjusting the refractive index of the hard coating layer 3 nearly equal to the refractive index of the base material 2, interference fringes and transmittance reduction produced by the reflection at the interface between the hard coating layer 3 and the base material 2 can be prevented.

Specifically, the hard coating layer 3 preferably contains one of or both rutile type titanium dioxide particles of 1 to 200 µm in particle diameter and particles having nucleuses containing titanium oxide covered by metal oxide with low photoactivation. This nucleus may contain metal oxide other than titanium oxide. As the metal oxide with low photoactivation, there is metal oxide of silicon, tin, zirconium, or antimony, or rutile type titanium dioxide. Further, composite oxide of them may be used.

In view of adjustment of refractive index, the composite material may be formed by combining not only these particles, but also metal oxide particles silicon, tin, zirconium, or antimony of 1 to 200 µm in particle diameter, or these composite oxide particles as a hard coating layer.

Further, when titanium is used as an inorganic material, in order to prevent reduction in light resistance of the hard coating layer 3 and the base material 2 due to its photoactivation (specifically, transmittance reduction due to yellowing and film pealing because of interference deterioration), titanium oxide having rutile type crystal structure or composite oxide particles having structures in which silicon dioxide wraps around titanium oxide are preferably used.

Here, the thickness of the hard coating layer 3 is preferably several micrometers in view of scratch resistance.

A primer layer may be provided at the interface between the base material 2 and the hard coating layer 3 for obtaining adhesion between the base material 2 and the hard coating layer 3.

For the low refractive index layers 5, 7, 9, a material having compression stress after layer formation is used. Silicon dioxide is cited as a material having compression stress, by which the layers can be formed at temperature without deforming plastic by the normal vacuum evaporation method.

For the high refractive index layers 6, 8, oxide of lanthanum, yttrium, cerium, gadolinium, scandium, ruthenium, and dysprosium as rare earth and titanium is used. Lanthanum titanate is preferable in points of low absorption of visible light and easy evaporation.

Here, the high refractive index layers 6, 8 of lanthanum titanate are preferable because they have no absorption of visible light but compression stress after layer formation. Specifically, the high refractive index layers 6, 8 are formed in a vacuum atmosphere at pressure more than 1 x 10⁻⁴ Pa and less than 1 x 10⁻² Pa.

At pressure equal to or less than 1 x 10⁻⁴ Pa, absorption at visible wavelengths occurs due to oxygen loss of titanate, and, at pressure equal to or more than 1 x 10⁻² Pa, tensile stress is generated. More preferably, they are formed in vacuum atmosphere at pressure equal to or more than 2 × 10⁻⁴ Pa and equal to or less than 8 x 10⁻³ Pa.

In the case where there are plural high refractive index layers, the pressure when the respective layers are formed within the above described pressure range may be varied. Further, the pressure can be changed in process of one high refractive index layer.

For example, preferably, the high refractive index layer 6 nearest to the base material 2 is formed by vacuum evaporation at pressure equal to or more than 5 x 10⁻³ Pa and less than 1 x 10⁻² Pa and the high refractive index layer 8 farthest from the base material 2 is formed by vacuum evaporation at pressure more than 1 × 10⁻⁴ Pa and equal to or less than 5 × 10⁻³ Pa. By setting such pressure conditions, the lens 1 more advantageous in heat resistance, scratch resistance, and appearance can be obtained.

As the layer structure of the antireflection coating 4, in the case of a three-layer film, a structure in which the optical thickness of each layer is set to λ/4 (design wavelength λ) and a structure in which the first and third layers are set to λ/4 and only the second layer is set to λ/2 are cited. The design wavelength λ is a center wavelength of visible light and preferably near 500 nm.

The antireflection coating 4 shown in Fig. 1 is configured by a layer having a thickness of λ/4, which is equal to a middle refractive index layer formed by the low refractive index layer 5, the high refractive index layer 6, and the low refractive index layer 7, the high refractive index layer 8 having a thickness of λ/4, and the low refractive index layer 9 having a thickness of λ/4. Here, since the refractive index slightly changes when the temperature of the base material 2 at the time of vacuum evaporation is changed, the design layer thickness is preferably adjusted when the temperature changes.

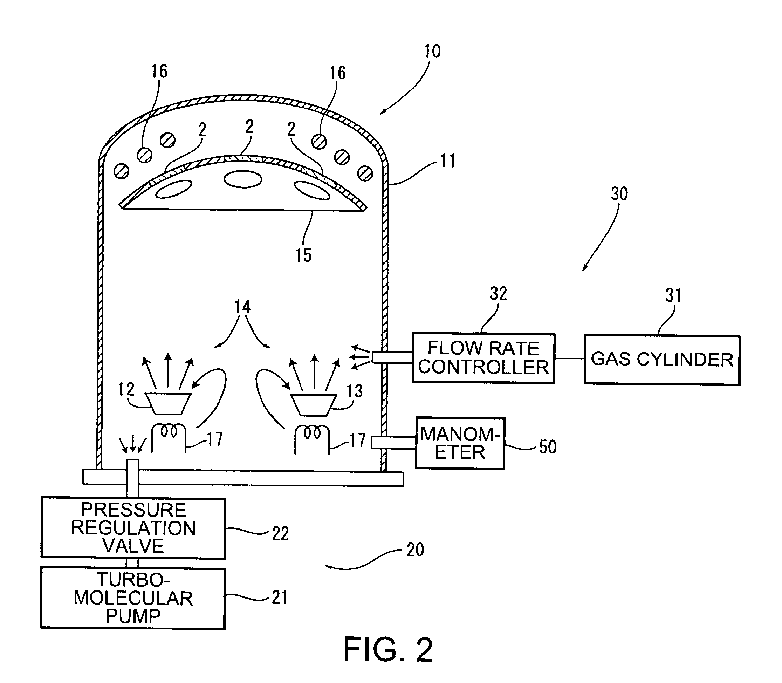

Fig. 2 is a schematic view of an evaporation device 10 used for manufacture of the antireflection coating 4 of the embodiment. In Fig. 2, the evaporation device 10 is a so-called electron beam evaporation device including a vacuum container 11, an exhaust unit 20, and a gas supply unit 30.

The vacuum container 11 includes evaporation sources (crucibles) 12, 13 in which evaporation materials are set, a heating unit 14 for heating and melting (evaporating) 'the evaporation materials in the evaporation sources 12, 13, a base material support 15 on which the base material 2 is mounted, a base material heater 16 for heating the base material 2, etc. within the vacuum container 11. Further, a cold trap for removing water remaining within the vacuum container 11, a unit for introducing a gas such as oxygen, ionizing the introduced gas, and applying it to the base material 2, a unit for controlling film thicknesses, etc. are provided according to need.

The evaporation sources 12, 13 are crucibles in which evaporation materials are set and located at the lower part of the vacuum container 11.

The heating unit 14 accelerates and deflects thermal electrons generated by heat generation of filaments 17 by an electron gun and applies them to the evaporation materials set in the evaporation sources 12, 13 for evaporation. So-called electron beam evaporation is performed. There is especially no limit to the acceleration current value, and the acceleration current value can be adjusted according to the required evaporation rate because it has a close relationship with the evaporation rate.

Further, as other methods for evaporating evaporation materials, there are methods for conducting the resistor of tungsten or the like to melt/vaporize evaporation materials (so-called resistance heating evaporation), for applying a laser beam with high energy to a material desired to be evaporated, etc.

The base material support 15 is a support on which the predetermined number of base materials 2 are mounted and located at the upper part facing the evaporation sources 12, 13 within the vacuum container 11. The base material support 15 preferably has a rotation mechanism for ensuring the uniformity of the antireflection coating 4 formed on the base material 2 and improving productivity.

The base material heater 16 is formed by an infrared lamp, for example, and located above the base material support 15. The base material heater 16 removes gas or water of the base material 2 by heating the base material 2, and ensure the adhesion of the layer formed on the surface of the base material 2.

A resistance heater or the like may be used other than the infrared lamp. However, in the case where the material of the base material 2 is plastic, the infrared lamp is preferably used.

The exhaust unit 20 is a unit for exhausting the interior of the vacuum container 11 to high vacuum, and includes a turbo-molecular pump 21 and a pressure regulation valve 22 for keeping the pressure within the vacuum container 11 constant.

The gas supply unit 30 includes a gas cylinder 31 filled with gas of Ar, N₂, O₂, or the like, and a flow rate controller 32 for controlling the flow rate of the gas. The gas filling the gas cylinder 31 is introduced into the vacuum container 11 via the flow rate controller 32.

A manometer 50 detects the pressure within the vacuum container 11. The pressure regulation valve 22 of the exhaust unit 20 is controlled according to control signals from a control part (not shown) based on the pressure value detected by the manometer 50, and the pressure within the vacuum container 11 is kept at a predetermined pressure value.

As pressure regulation, there are a method for changing the conductance of the exhaust port, a method for changing the introduction amount by introducing gas, etc. and either may be used. Accordingly, the pressure within the vacuum container 11 can be controlled also by a method for controlling the flow rate controller 32 for controlling the flow rate of the gas supplied from the gas cylinder 31 of the gas supply unit 30.

Further, in the case where the pressure is regulated by the residual pressure after exhaust without special regulation, the adjustment of film thickness is required because sometimes the refractive index changes. If pressure control is not especially performed, the pressure can greatly change during evaporation.

The base material 2 on which the hard coating layer 3 has been formed is mounted on the above described base material support 15 within the vacuum container 11, and then, the evaporation device 10 is activated to form the antireflection coating 4.

According to the embodiment, there are advantages as follows.

(1) Since both the low refractive index layers 5, 7, 9 and the high refractive index layers 6, 8 have compression stress, even when the plastic base material 2 expands due to temperature rise, because each layer of the antireflection coating 4 has compression stress, the antireflection coating 4 can expand while allowing the compression stress of each layer to be released. Therefore, the antireflection coating 4 expands while sufficiently following the base material 2 and cracking becomes less likely to occur in the antireflection coating 4. As a result, the temperature at which cracking occurs in the antireflection coating 4 can be made higher and the heat resistance of the plastic spectacle lens 1 can be improved.

(2) Since the pressure when the high refractive index layers 6, 8 are formed is above 1 x 10⁻⁴ Pa, the high refractive index layers 6, 8 have compression stress and the absorption of visible light by the high refractive index layers 6, 8 due to oxygen loss of titanate can be suppressed.

(3) At pressure within the pressure range of the embodiment, the high refractive index layers 6, 8 having compression stress with less absorption of visible light can be formed by a simple vacuum evaporation method.

(4) When the temperature environment at the antireflection coating 4 formation is equal to or more than 25°C and equal to or less than 150°C, also the temperature of the base material 2 becomes equal to or more than 25°C and equal to or less than 150°C according to the temperature environment. Therefore, when a layer containing titanate of a rare earth element is formed by normal vacuum evaporation in an atmosphere at pressure less than 1 x 10⁻² Pa, the layer has compression stress more reliably, and the plastic spectacle lens 1 with improved heat resistance is obtained. Further, since the antireflection coating 4 is formed at temperature equal to or less than the deformation temperature of the base material 2 of the plastic spectacle lens 1, the deformation of the plastic spectacle lens is smaller. Furthermore, since the film is formed at 25°C or more, a special cooling device is not required.

(5) Since the refractive index of the base material 2 is equal to or more than 1.6, the refractive index is easily conformed by the hard coating layer 3 containing titanium oxide with high refractive index. Therefore, the reflection at the interface between the base material 2 and the hard coating layer 3 can be suppressed, and the occurrence of the interference fringes can be suppressed to raise the transmittance.

(6) Since silicon dioxide has large compression stress by the normal vacuum evaporation method and lanthanum titanate also has compression stress within the above described pressure range, the plastic spectacle lens 1 with further improved heat resistance can be manufactured.

(7) The plastic spectacle lens 1 with improved heat resistance can be obtained. In the spectacle lens used with naked eyes, the improvement in heat resistance is especially helpful in appearance and safety.

(8) The maintenance cycle can be made longer because ion assist or the like is not performed, and accordingly, the cost of manufacturing can be suppressed.

(9) Since silicon dioxide used for the low refractive index layers 5, 7, 9 transmits ultraviolet, the degree of transmission of ultraviolet is determined by the high refractive index layers 6, 8. However, lanthanum titanate used for the high refractive index layers 6, 8 transmits even from visible light to light at wavelength near 275 nm. Here, by providing the hard coating layer 3 containing at least one of rutile type titanium dioxide particles with low photoactivation and particles having nucleuses containing titanium oxide covered by metal oxide with low photoactivation on the surface of the base material, ultraviolet can be absorbed by the hard coating layer. Therefore, the light resistance of the base material 2 and the hard coating layer 3 itself can be improved.

(10) The plastic spectacle lens 1 with good light resistance can be formed by combination with the hard coating layer 3 with light resistance.

(11) Since the refractive index of the base material 2 is high, the plastic spectacle lens 1 can be made thinner.

### Working examples

Next, working examples of the invention will be described.

Note that the invention is not limited to the following examples, but includes modifications, improvements, etc. within the range in which the object of the invention can be achieved.

### Working example 1

For the base material 2 of the plastic spectacle lens 1, product name lens for Seiko Super Sovereign manufactured by Seiko Epson Corporation (refractive index 1.67) is used. The base material 2 is applied with a coating liquid, which will be described as below, and cured to form the hard coating layer 3. Then, the antireflection coating 4 is formed.

### (1) Preparation of coating liquid

74.93g of γ-glycidoxypropyl trimethoxysilane and 37.61 g of γ-glycidoxypropyl methyldimethoxysilane, 38.2 g of 0.1 normal aqueous hydrochloric acid solution are input to a reaction container with stirring bar, and stirred for 60 minutes. Then, 275.11 g of distilled water is input and stirred for another 60 minutes. Subsequently, 584.39 g of composite sol of rutile type titanium dioxide, zirconium oxide, silicon oxide, and tin oxide (product name "OPTOLAKE 1120Z" (11RU-7/A8) manufactured by Catalysts & Chemicals Ind. Co., Ltd.) and 0.30 g of silicon surfactant (product name "L-7604" manufactured by Nippon Unicar Co., Ltd.) are added and sufficiently stirred to provide a coating liquid.

### (2) Application and curing of coating liquid

The coating liquid obtained by the above described (1) preparation is applied by the spin coat method on the convex surface of the base material 2, and heated and cured for 0.5 hours at 135°C. Then, the same operation is performed on the concave surface and it is heated and cured for 2.5 hours at 135°C to provide the base material 2 with the hard coating layer 3 formed thereon.

### (3) Formation of antireflection coating 4

As the evaporation device 10, a sequential vacuum evaporation device manufactured by Shincron Co., Ltd. is used (the electron gun is JEBG-102UH0 manufactured by JEOL. Ltd.).

The base material 2 with the hard coating layer 3 formed thereon obtained by the above described (2) operation is mounted on the base material support 15 within the evaporation device 10. Then, ion cleaning is performed on the surface of the hard coating layer 3 (after oxygen gas is plasma decomposed using an ion gun RIS-120D manufactured by Shincron Co., Ltd., ions are accelerated, drawn, and applied to the surface of the base material 2). The processing condition is that the oxygen flow rate is 20 sccm, the acceleration voltage of oxygen ions is 500V, the acceleration current is 300 mA, and processing time is 120 seconds.

Then, the antireflection coating 4 (the low refractive index layers 5, 7, 9 and the high refractive index layers 6, 8) is formed by alternately melting and vaporizing silicon dioxide and lanthanum titanate raw material (Merck Japan Ltd.: H4)) located in the evaporation sources 12, 13 with electron beams. The antireflection coating 4 is formed by controlling the pressure at the time of formation while adjusting the oxygen flow rate. Specifically, when the high refractive index layers 6, 8 are formed, the pressure is controlled while the oxygen flow rate is adjusted.

Further, the temperature environment within the evaporation device 10 at the time of layer formation is set to 50°C. Furthermore, the current values of electron beams are set to 100 mA for melting of silicon dioxide and 300 mA for melting of lanthanum titanate.

The structure of the antireflection coating 4 of the working example has design wavelength λ of 500 nm, and film structure of silicon dioxide (10.4 nm)/lanthanum titanate (44.8 nm)/ silicon dioxide (8.6 nm)/lanthanum titanate (66.0 nm)/silicon dioxide (87.2 nm).

Here, the refractive index of silicon dioxide is 1.46 and the refractive index of lanthanum titanate is 2.04. Further, the deposition rate of silicon dioxide is about 80 nm/min and the deposition rate of lanthanum titanate is about 40 nm/min.

In the case of a gas is introduced, the gas may be ionized and applied using an ion gun or the like, or the introduced gas is made into a plasma state and applied to the base material (ion plating method).

Here, in Working example 1, the pressure at the layer formation is set to 2 × 10⁻⁴ Pa (Working example 1-1), 1 × 10⁻³ Pa (Working example 1-2), 5 × 10⁻³ Pa (Working example 1-3), and 8 x 10⁻³ Pa (Working example 1-4).

### (4) Evaluation

The evaluation of the plastic spectacle lens 1 and the high refractive index layers 6, 8 (lanthanum titanate layers) obtained in Working example 1 is performed in the following manner. The evaluation results are shown in Figs. 3 to 6 and Table 1. Note that, also in the case where the temperature environment at the antireflection coating 4 formation is set to 25°C or 150°C, the same results as those in Working example 1 in Table 1 are obtained. However, in the case where the temperature is set to 160°C, the plastic spectacle lens 1 turns into brownish and deforms. Further, regarding Working example 2 and Comparative example 1, which will be described later, the pressure of the atmosphere at the time of high refractive index layers 6, 8 formation is set to 1 x 10⁻³ Pa only, and the only the evaluation of heat resistance and light resistance is performed. Further, in the evaluation of stress and refractive index, also film formation with the current values at the time of lanthanum titanate layer formation set to 250 mA and 350 mA is performed.

### Stress evaluation of high refractive index layer

A lanthanum titanate layer having a thickness of 100 nm is formed on a silicon wafer (diameter 10 cm, thickness 525 µm) while varying the pressure at the time of formation, and the values are calculated from the changes in warpage before and after the formation. The stress evaluation is performed with a lanthanum titanate single layer film (FT-900 manufactured by NIDEK Co., Ltd.).

Fig. 3 shows evaluation results with the horizontal axis as pressure at the time of layer formation and the vertical axis as stress (the current value of the electron beam at the time of layer formation is used as a parameter). The stress along the vertical axis indicates compression by negative values and tension by positive values.

From Fig. 3, it is seen that the stress is not very much dependent on the current value but affected by the pressure at the time of layer formation. The stress changes greatly to the tension side from near 1 × 10⁻² Pa toward the high pressure side (low vacuum side). It is conceivable that the cause is the film density becomes lower because the average free path of the evaporation particles is reduced (becomes shorter) due to pressure rise and the energy when colliding against the base material is reduced.

### Refractive index evaluation

The refractive index of the layer that has been stress evaluated is measured by a spectral ellipsometer (multilayer film spectroscopic ellipsometer manufactured by SOPRA).

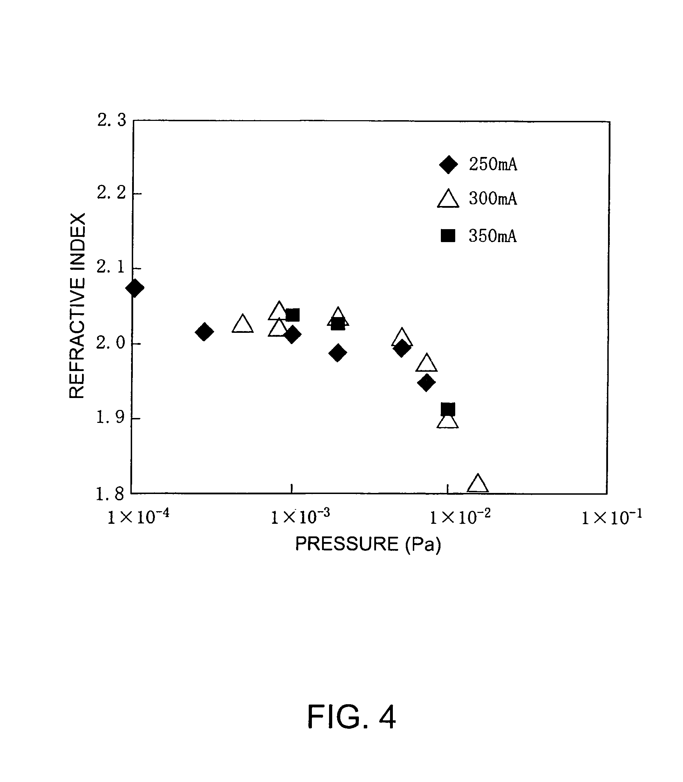

Fig. 4 shows evaluation results with the horizontal axis as pressure at the time of layer formation and the vertical axis as refractive index (the current value of the electron beam at the time of layer formation is used as a parameter).

From Fig. 4, it is seen that the refractive index is not very much dependent on the current value but affected by the pressure at the time of layer formation. The refractive index changes from near 1 x 10⁻² Pa similarly to the stress and the refractive index is also reduced. It is conceivable that the cause is the same as that for the stress that the film density becomes lower.

### Transmittance

A lanthanum titanate layer having a thickness of about 100 nm is formed on a quartz base material having a thickness of 0.7 mm, and the transmittance is evaluated. Here, since interference occurs depending on the layer thickness, absorption coefficient α is calculated from transmission and reflection data, and the transmittance is calculated by removing the influence by the interference from the calculated α and evaluated (a spectrophotometer U-3500 manufactured by Hitachi Ltd.).

Fig. 5 shows evaluation results with the horizontal axis as pressure at the time of layer formation and the vertical axis as transmittance at 500 nm (the current value of the electron beam at the time of layer formation is used as a parameter).

From the transmittance data in Fig. 5, it is seen that there is absorption of light in the visible light region at 1 × 10⁻⁴ Pa or less. On the other hand, the absorption of visible light is reduced at 2 × 10⁻⁴ Pa or more. It is conceivable that the cause is the properties of the layer become closer to those of metal because oxygen in lanthanum titanate becomes easier to desorb as the pressure becomes too low, and thereby, the absorption at visible light is increased and the refractive index is also increased.

### Spectroscopic characteristics of antireflection coating

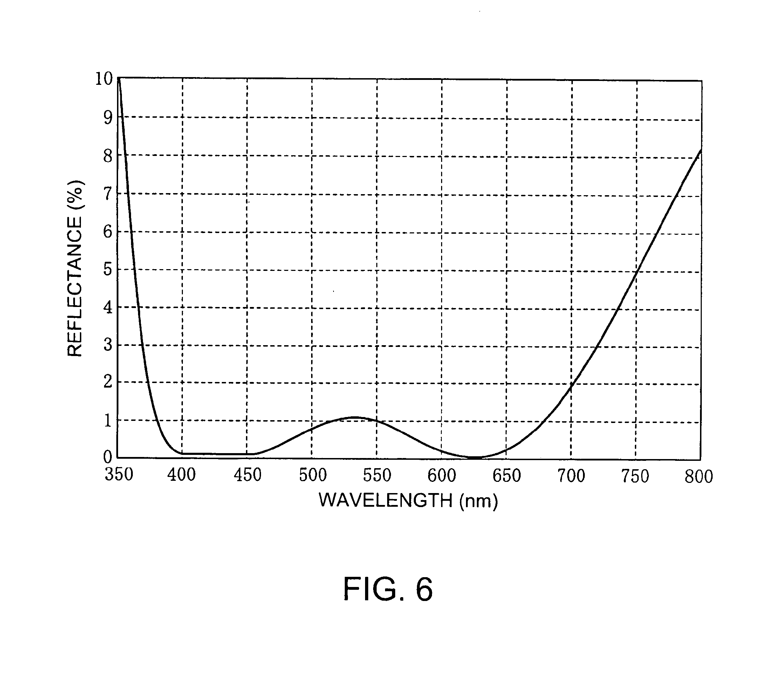

Fig. 6 shows calculated values of reflection characteristic in the working example. The horizontal axis is wavelength and the vertical axis is reflectance.

### Light resistance

The lens is exposed to a sunshine weather meter with a xenon lamp (manufactured by Suga Test Instruments Co., Ltd.; WEL-SUN-HC) for 80 hours, and then, the degree of change in surface condition is visually evaluated by dividing into following phases.
O: No change is recognized
X: Cracking occurs

### Heat resistance

The outer peripheral of the plastic spectacle lens 1 is cut so that the plastic spectacle lens 1 fits within a frame of the plastic spectacle lens 1, and the cut plastic spectacle lens 1 is fit in the frame. The lens is placed in an atmospheric oven in that condition, and the temperature at which cracking occurs by heating it at constant temperature is obtained as heat resistance temperature. Heating in the oven is performed by raising the temperature from 50°C by 5°C, and cracking is observed after the lens is left for 30 minutes at each temperature. The determination of cracking is performed by visually determining the presence or absence of cracking by holding up the lens to a normal fluorescent lamp.

### Scratch resistance

After the plastic lens surface is scratched in ten times of reciprocating motion (amplitude 30 mm) while steel wool (Japan Steel Wool #0000) is pressed with weight of 1 kgf thereto, occurrence of scratch is visually observed and evaluated in the following three phases.
A: No scratch is seen
B: Scratch changed in interference color is seen
C: Clouded scratch is seen

### Appearance evaluation with constant temperature and humidity

The plastic lens is placed within a thermohydrostat bath (temperature 60°C, humidity 100%) and left for 10 days, and then, whether minute irregularities are produced on the lens surface is visually observed and evaluated in the following three phases.
A: No change
B: Vaguely recognized
C: Clearly recognized

### Working example 2

The plastic spectacle lens 1 is formed in the same manner as that in Working example 1 except that the coating liquid and the application and curing thereof in Working example 1 is altered as below and the material of the base material 2 and the film thickness of each layer of the antireflection coating 4 are altered.

### (1) Preparation of coating liquid

1050 g of butyl cellosolve and, as sol containing particles with nucleuses containing titanium oxide covered by metal oxide with low photoactivation, 6500 g of methanol-dispersed titanium dioxide-zirconium oxide-silicon oxide composite fine particle sol (product name "OPTOLAKE 1120Z" (SE-55), solid concentration 20 wt% manufactured by Catalysts & Chemicals Ind. Co., Ltd.) are mixed in a reaction container with stirring bar, and then, 1450 g of γ-glycidoxypropyl trimethoxysilane and 235 g of tetramethoxysilane are mixed therein. 550 g of 0.05N aqueous hydrochloric acid solution is dropped while stirring, and, after four hours' stirring, ripened in a day and a night. Then, 12 g of aluminum (III) acetylacetonate and 3 g of silicon surfactant (product name "FZ-2110" manufactured by Nippon Unicar Co., Ltd.) are added to the liquid and, after four hours' stirring, ripened in a day and a night to provide a hard coating liquid.

The particles of the composite fine particle sol used here are particles with nucleuses containing titanium oxide covered by metal oxide with low photoactivation.

### (2) Application and curing of coating liquid

The hard coating liquid obtained by the above described (1) preparation is applied by spin coating to a spectacle lens with refractive index of 1.60 (lens material for Seiko Super Luscious manufactured by Seiko Epson Corporation). After application, the lens is airdried at 80°C for 20 minutes and fired at 120°C for 120 minutes. Thus obtained cured coating (hard coating layer 3) has a thickness of about 2.3 µm.

(3) Subsequently, the same processing is performed as that in Working example 1 and the same evaluation is performed. However, the layer formation of the lanthanum titanate layer is performed at pressure of 1 × 10⁻³ Pa only. Further, since the refractive index of the hard coating is low, the layer structure of the antireflection coating is changed as below.

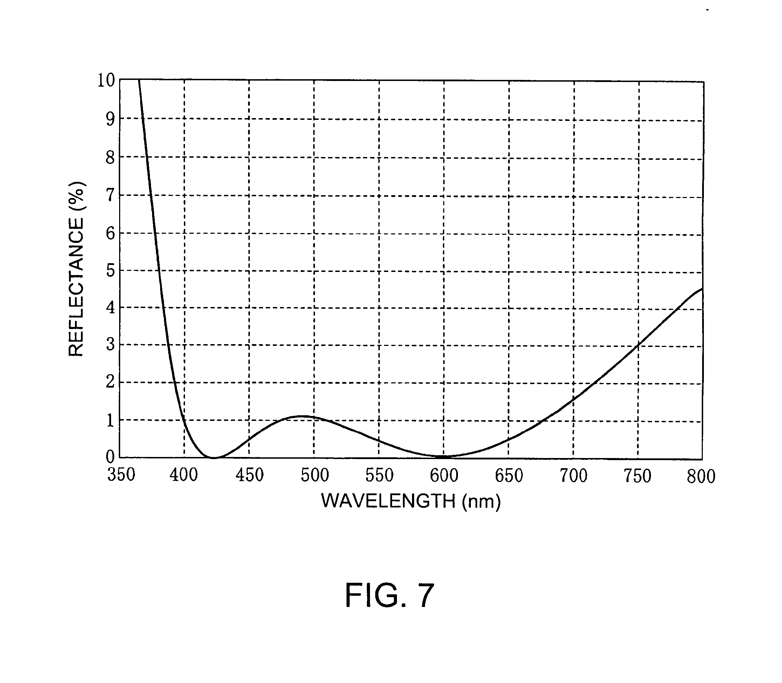

The design wavelength λ is 500 nm, and film structure is silicon dioxide (8.6 nm)/lanthanum titanate (40.4 nm)/silicon dioxide (10.7 nm)/lanthanum titanate (65.8 nm)/silicon dioxide (88.8 nm). Fig. 7 shows calculated values of reflection characteristics.

Further, the evaluation of stress and refractive index is not performed and the acceleration current value of lanthanum titanate is set to 300 mA only.

### Working example 3

(1) Preparation of coating liquid, (2) Application and curing of coating liquid, (3) Formation of antireflection coating, and (4) Evaluation are performed in the same manner as that in Working example 1 except that composite sol of anatase type titanium dioxide, zirconium oxide, and silicon oxide (product name "OPTOLAKE 1820Z" (U-25/A8) manufactured by Catalysts & Chemicals Ind. Co., Ltd.) is used as the sol of inorganic oxide fine particles in (1) Preparation of coating liquid of Working example 1.

### Working example 4

The plastic spectacle lens 1 is formed in the same manner as that in Working example 1 except that the film formation pressure of the antireflection coating 4 in Working example 1 is changed. Specifically, the pressure at the time of film formation of the high refractive index layer 6 is set to 8 x 10⁻³ Pa and the pressure at the time of film formation of the high refractive index layer 8 is set to 2 × 10⁻⁴ Pa in Working example 4-1, the pressure at the time of film formation of the high refractive index layer 6 is set to 8 × 10⁻³ Pa and the pressure at the time of film formation of the high refractive index layer 8 is set to 1 × 10⁻³ Pa in Working example 4-2, and the pressure at the time of film formation of the high refractive index layer 6 is set to 5 x 10⁻³ Pa and the pressure at the time of film formation of the high refractive index layer 8 is set to 2 × 10⁻⁴ Pa in Working example 4-3. Evaluation is performed in the same manner as that in Working example 1.

### Comparative example 1

The plastic spectacle lens 1 is formed in the same manner as that in Wording example 1 except that the pressure at the layer formation in Working example 1 is set to 1 × 10⁻⁴ Pa in Comparative example 1-1, 1 × 10⁻² Pa in Comparative example 1-2, and 2 × 10⁻² Pa in Comparative example 1-3. Evaluation is performed in the same manner as that in Working example 1.

### Comparative example 2

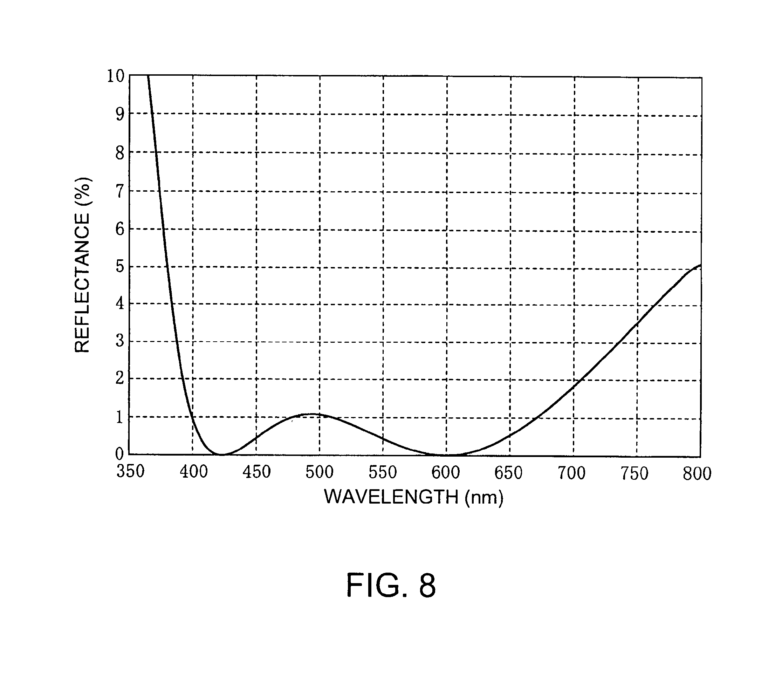

In the formation of the antireflection coating 4 of Working example 1, the antireflection coating 4 having substantially the same film thickness of each layer as that of Working example 1 using zirconium oxide in place of lanthanum titanate as the high refractive index layers 6, 8. The layer structure is silicon dioxide (19.6 nm)/zirconium dioxide (43.4 nm)/silicon dioxide (8.7 nm)/zirconium dioxide (72.2 nm)/silicon dioxide (85.8 nm). Fig. 8 shows spectral reflection characteristics thereof.

However, the formation of zirconium oxide is performed at pressure of 1 × 10⁻³ Pa only. The acceleration current value at the time of zirconium dioxide formation is set to 280 mA. Further, the evaluation of stress and refractive index is not performed as well as in Working example 2.

Table 1 shows evaluation results of heat resistance, scratch resistance, appearance evaluation with constant temperature and humidity, and light resistance of the respective working examples and comparative examples to pressure at the time of layer formation.

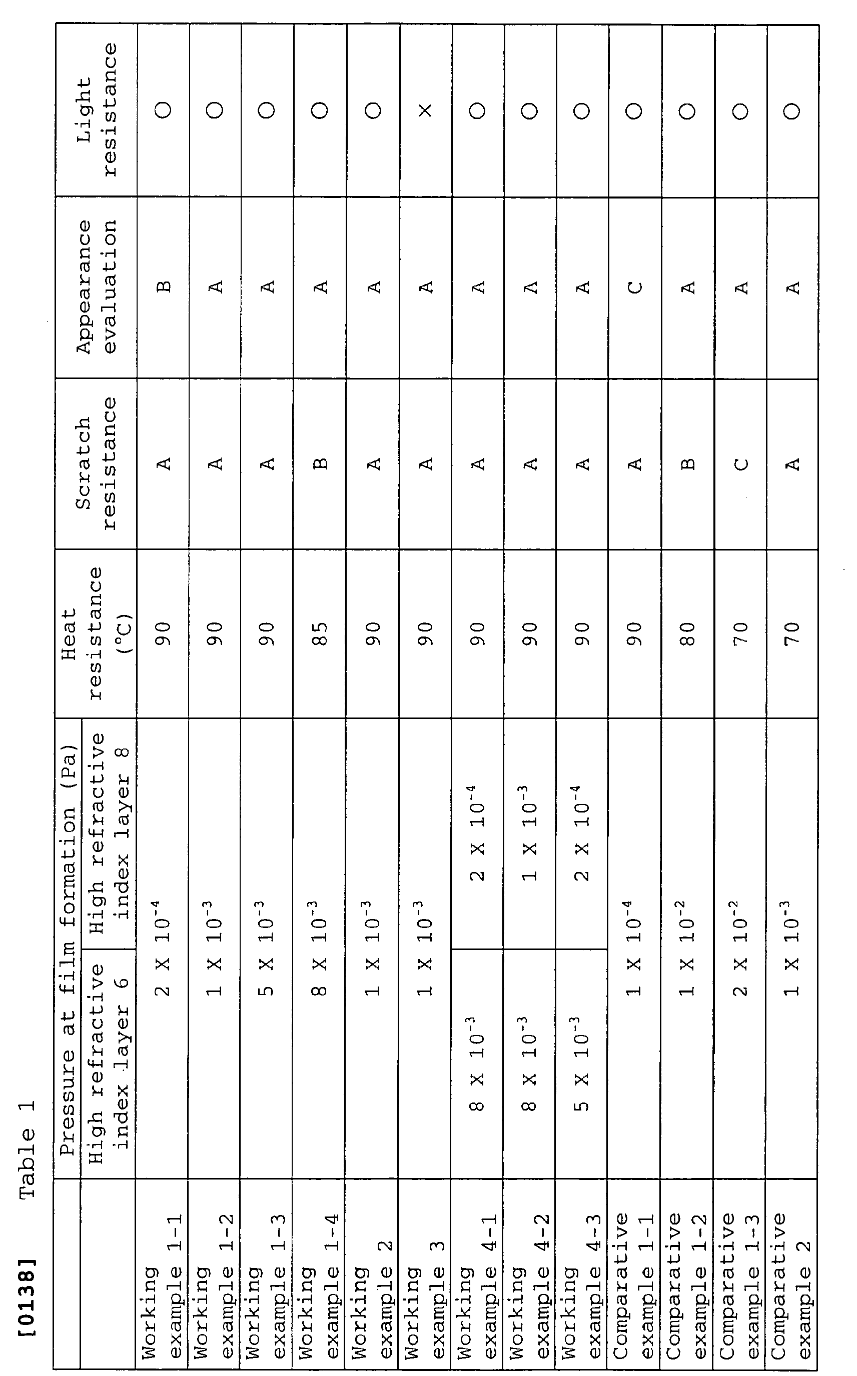

From the results in Table 1, it is seen that, in working examples, the lens is formed at pressure less than 1 x 10⁻² Pa and advantageous in heat resistance, and the lens is formed at pressure more than 1 x 10⁻⁴ Pa and advantageous in lens appearance. That is, it has been confirmed that the plastic spectacle lens 1 with improved heat resistance can be easily manufactured using lanthanum titanate formed by setting the pressure at the time of evaporation (film formation) more than 1 x 10⁻⁴ Pa and less than 1 x 10⁻² Pa as the antireflection coating 4. Further, from the evaluation results of scratch resistance, the film is preferably formed at pressure less than 8 x 10⁻³ Pa. Furthermore, from the appearance evaluation with constant temperature and humidity, the film is preferably formed at pressure more than 2 × 10⁻⁴ Pa.

On the other hand, Comparative example 1-1 is advantageous in heat resistance and scratch resistance but poor in appearance because the pressure at the time of film formation is 1 × 10⁻⁴ Pa. Further, it is also poor in transparency (see transmittance in Fig. 5). Comparative examples 1-2 and 1-3 are poor in heat resistance and scratch resistance because the pressure at the time of film formation is 1 x 10⁻² Pa or more. Comparative example 2 is poor in heat resistance because the high refractive index contains no titanate.

Further, from the results of Working example 4, it is also seen that the preferable pressure range can be changed by changing pressure conditions of the respective layers of the antireflection coating. That is, by setting the high refractive index layer 6 into a high pressure condition and the high refractive index layer 8 into a low pressure condition, the antireflection coating that satisfies heat resistance, scratch resistance, appearance evaluation with constant temperature and humidity can be obtained. The scratch resistance is B in Working example 1-4 (8 x 10⁻³ Pa), however, the scratch resistance can be improved by setting the film formation pressure of the high refractive index layer 8 to 2 × 10⁻⁴ Pa (Working example 4-1), 1 × 10⁻³ Pa (Working example 4-2) without reducing the heat resistance or appearance evaluation with constant temperature and humidity. Further, the appearance evaluation with constant temperature and humidity is B in Working example 1-1 (2 x 10⁻⁴ Pa), however, the appearance evaluation with constant temperature and humidity can be improved by setting the film formation pressure of the high refractive index layer 6 to 8 × 10⁻³ Pa (Working example 4-1) and 5 × 10⁻³ Pa (Working example 4-3) without reducing the heat resistance or scratch resistance.

Furthermore, it has been confirmed that, as shown in Table 1, the light resistance of the plastic spectacle lenses 1 in which the hard coating layer 3 contains rutile type titanium dioxide in Example 1 and particles having nucleuses containing titanium oxide covered by metal oxide with low photoactivation in Example 2 is improved compared to the light resistance of the plastic spectacle lens 1 of Example 3 containing anatase type titanium dioxide particles.

The invention is not limited to the above described embodiments, and the invention includes modification, improvements, etc. within the range in which the object of the invention can be achieved.

For example, the design of the antireflection coating 4 depends on required reflection characteristics or the like, and the film thickness or the like may be changed.

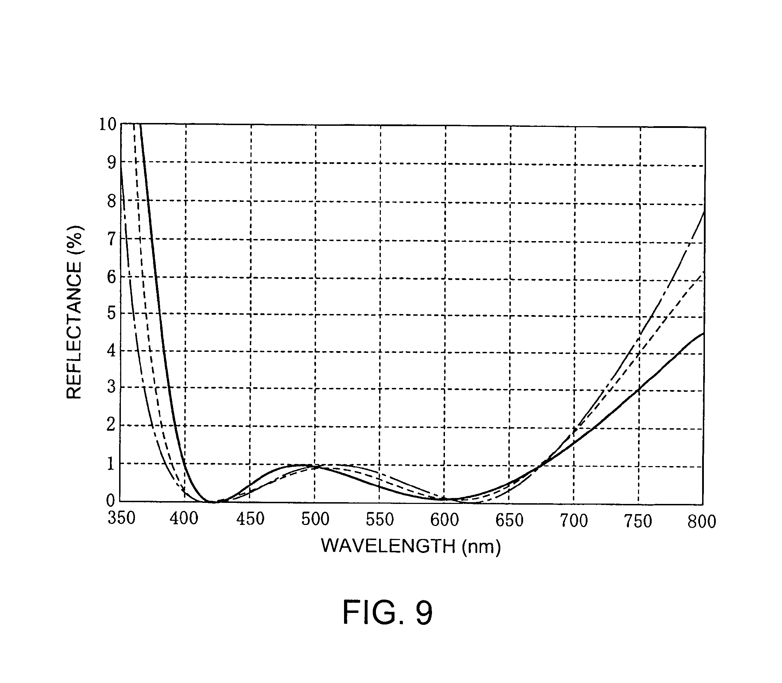

Fig. 9. shows examples of the antireflection coating 4 formed by silicon dioxide and lanthanum titanate by reflection characteristics. The design center waveform λ is 500 nm, the refractive index of silicon dioxide is 1.46, and the refractive index of lanthanum titanate is 2.04.

The solid line shows a five-layer structure with the first to third layers as equivalent layers, and the film structure is silicon dioxide (10.4 nm)/lanthanum titanate (44.8 nm)/silicon dioxide (8.6 nm)/lanthanum titanate (65.9 nm)/silicon dioxide (87.2 nm).

The dotted line and dashed line show seven-layer structures in which the first to third layers and the fourth to sixth layers form equivalent layers.

The dotted line is the film structure of silicon dioxide (35.9 nm)/lanthanum titanate (14.1 nm)/silicon dioxide (54.1 nm)/lanthanum titanate (40.9 nm)/silicon dioxide (13.5 nm) /lanthanum titanate (67.7 nm)/silicon dioxide (84.8 nm).

The dashed line is the film structure of silicon dioxide (15.8 nm)/lanthanum titanate (8.74 nm)/silicon dioxide (166.7 nm)/lanthanum titanate (32.7 nm)/silicon dioxide (17.4 nm) /lanthanum titanate (58.5 nm)/silicon dioxide (83.9 nm).

Further, a film having repellency and antifogging property may be applied to the surface of the antireflection coating 4. The composition of lanthanum titanate is at a ratio of about 1:1:3, however, slight composition shift may be accommodated.

Furthermore, the best structure and method for implementing the invention have been disclosed in the above description, however, the invention is not limited to those. That is, the invention has been specifically illustrated and described mainly with respect to particular embodiments, however, one skilled in the art can make various modifications to the above described embodiments in shapes, materials, number, and other detailed structures without departing the technological sprit and target scope of the invention.

Therefore, since the above disclosed description limiting the shapes and materials are illustratively described for easy under standing of the invention but not for limiting the invention, the invention includes the description in names of members without part or entire limitation of the limitations of those shapes and materials.

The invention can be applied not only to plastic spectacle lenses, but also to dust-proof glass, dust-proof quartz, condenser lenses, prisms, antireflection for optical disk, antireflection for display, antireflection for solar battery, and optical isolators.

## Claims

1. A method for manufacturing a plastic optical component having an optical multilayer film, wherein the optical multilayer film has a low refractive index layer and a high refractive index layer, and
wherein a layer containing titanate of a rare earth element is formed in a vacuum atmosphere at pressure more than 1 x 10⁻⁴ Pa and less than 1 x 10⁻² Pa as the high refractive index layer of the optical multilayer film.

2. The method for manufacturing the optical component according to claim 1, wherein the high refractive index layer closest to a base material of the optical component is formed in a vacuum atmosphere at pressure equal to or more than 5 x 10⁻³ Pa and the high refractive index layer farthest from the base material of the optical component is formed in a vacuum atmosphere at pressure equal to or less than 5 × 10⁻³ Pa.

3. The method for manufacturing the optical component according to claim 1, wherein a layer containing lanthanum titanate is formed as the high refractive index layer.

4. The method for manufacturing the optical component according to claim 3, wherein a layer containing silicon dioxide is formed as the low refractive index layer.

5. An optical component manufactured by the method for manufacturing the optical component according to claim 1.

6. The optical component according to claim 5, wherein the optical component is a spectacle lens.

7. The optical component according to claim 5, comprising:
a lens base material;
a hard coating layer provided on the lens base material; and
an antireflection coating provided on the hard coating layer and having a low refractive index layer containing silicon dioxide and a high refractive index layer containing lanthanum titanate,
wherein the hard coating layer includes at least one of the following (1) and (2):
(1) rutile type titanium dioxide particles; and
(2) particles with nucleuses containing titanium oxide covered by metal oxide with low photoactivation.
